Europäisches Patentamt

European Patent Office

Office européen des brevets

(19)

(11) Veröffentlichungsnummer: **0 037 529**
A1

(12) # EUROPÄISCHE PATENTANMELDUNG

(21) Anmeldenummer: 81102285.4

(22) Anmeldetag: 26.03.81

(51) Int. Cl.³: **G 03 F 7/00**
**G 02 B 5/28, H 04 N 9/04**

(30) Priorität: 03.04.80 DE 3013142
30.09.80 DE 3036943

(43) Veröffentlichungstag der Anmeldung:
14.10.81 Patentblatt 81/41

(84) Benannte Vertragsstaaten:
CH FR GB LI NL

(71) Anmelder: AGFA-GEVAERT Aktiengesellschaft
Patentabteilung
D-5090 Leverkusen 1(DE)

(72) Erfinder: Stemme, Otto, Dr.
Heideckstrasse 29
D-8000 München 19(DE)

(72) Erfinder: Krekeler, Ulrich
Frauenschuhstrasse 38
D-8122 Penzberg(DE)

(72) Erfinder: Giglberger, Dieter, Dr.
Finsingerweg 18
D-8025 Unterhaching(DE)

(72) Erfinder: Ruf, Wolfgang
Bayrischzeller Strasse 23
D-8000 München 90(DE)

(72) Erfinder: Fuhrmann, Heinz
Sachranger Strasse 44
D-8000 München 90(DE)

(54) Verfahren zur Herstellung eines Fotoempfängers mit einem multichroitischen Farbstreifenfilter.

(57) Zur Herstellung von Fotoempfängern mit deckungsgerechten, konturenscharfen, absorptionsfreien Farbstreifenfiltern wird vorgeschlagen, die ineinandergeschachtelten Filterstreifensysteme ($F_1$, $F_2$, $F_3$) in aufeinanderfolgenden Verfahrensstufen jeweils unter Beschichten des Substrates mit Fotolack, Aufbelichten einer jedem Streifensystem zugeordneten Maske, Entwickeln des Fotolacks, Aufdampfen der gewünschten Interferenzschichten für die betreffende Filterfarbe und anschließendem Ablösen des verbliebenen Fotolacks aufzubringen.

Diese Filterstreifensysteme werden direkt auf dem Fotoempfänger (C) oder auf einer Platte (G), die anschließend auf den Fotoempfänger aufgekittet wird, aufgebracht, wobei ein zusätzlicher undurchsichtiger Maskenrahmen (M) zur Fernhaltung von Streulicht erzeugt wird.

./...

Fig. 8

# AGFA-GEVAERT AG 0037529

## LEVERKUSEN

CAMERA-WERK MÜNCHEN
**PATENTABTEILUNG**

CW 2362.1 PO/MO

01.04.81

10-hl

0336C

## Verfahren zur Herstellung eines Fotoempfängers mit einem multichroitischen Farbstreifenfilter

Die Erfindung betrifft ein Verfahren zur Herstellung eines Fotoempfängers mit einem multichroitischen Farbstreifenfilter.

Die Herstellung von multichroitischen Filterstreifen für Fotoempfänger zum Zwecke der Chiffrierung bzw. Dechiffrierung zur Erzeugung bzw. zur Wiedergabe von Farbbildern ist bisher nicht zufriedenstellend gelöst.

So ist z. B. ein Farbstreifenfilter mit bis zu 80 Farbfilterstreifen pro mm, bestehend aus abwechselnd nebeneinanderliegenden Einzelfiltern aus den Farben blau, grün und rot - in Transmission gesehen - bisher nicht auf dem Weltmarkt erhältlich.

Die Problematik liegt in der hohen Streifendichte, wobei die Farbstreifen äußerst kantenscharf sein müssen.

Farbcodierungen über Absorptionsfilter, die durch Einfärbungen von Fotoresist-Schichten oder auf fotografischem Wege hergestellt werden, haben den Nachteil, daß sie hohe Lichtverluste erzeugen und die Filterkurven nicht steilflankig genug sind bzw. daß das Auflösungsvermögen nicht ausreicht, um kantenscharfe Konturen zu erzeugen.

Interferenzschichtfilterüberzüge auf separaten Substraten, die mit speziellen Fotoresistschichten (Ätzmaske) partiell abgedeckt werden, so daß die freiliegenden Schichten durch Ionensprühätzen entfernt werden können, sind nicht genügend kantenscharf, um einwandfreie Chiffrierung zu erlauben, da die Ätzmaske sehr stark aufgetragen werden muß, weil auch sie teilweise durch den Ätzprozeß abgebaut wird. Außerdem lassen sich nur solche Aufdampfsubstanzen auftragen, die eine hohe Ionenätzrate aufweisen. Diese Schichtsubstanzen sind aber ausnahmslos sehr weich und auch gegen chemische Umwelteinflüsse nicht ausreichend stabil.

Die Anwendung des Ionensprühätzverfahrens auf unmittelbar auf dem Fotoempfänger angeordnete Überzüge zur Entfernung der unerwünschten Bereiche ist nicht durchführbar, weil der Fotoempfänger-Chip durch den Ionenbeschuß zerstört würde.

Es ist das Ziel der Erfindung, ein Verfahren zu schaffen, mit dem Fotoempfänger deckungsgerecht mit konturenscharfen, absorptionsfreien multichroitischen Farbstreifenfiltern mit sehr steilflankigen spektralen Transmissionsverläufen hergestellt werden können.

Gemäß der Erfindung wird dies dadurch erreicht, daß die ineinandergeschachtelten Filterstreifensysteme in aufeinanderfolgenden Verfahrensstufen jeweils unter Beschichten des Substrates mit Fotolack, Aufbelichten einer jedem Streifensystem zugeordneten Maske, Entwickeln des Fotolacks, Aufdampfen der gewünschten Interferenzschichten für die betreffende Filterfarbe und anschließendem Ablösen des verbliebenen Fotolacks aufgebracht werden.

Die Farbfilterfunktion von dielektrischen Schichten beruht darauf, daß durch die Interferenz der abwechselnd hoch- und niedrigbrechenden, in ihrer Dicke genau berechneten Schichten im Bereich des optischen Lichtes in Transmission gesehen der unerwünschte Bereich des Lichtes, den es auszufiltern gilt, durch Reflexion unterdrückt wird.

Im Fall des auf separatem Substrat aufgebrachten Farbfilterstreifens nach der Hauptanmeldung werden die Filter mit dem Chip so verbunden, daß die Filterschichtseite auf die Fotosensoren aufgelegt wird.

Bei kon- oder divergierenden optischen Strahlengängen wie sie z.B. in der Regel bei Abfragen von Bildinhalten, z.B. über Schwingspiegelsysteme und dergleichen, also bei Anwendung von mit Farbfiltern versehenen Fotodioden in Festkörper-Technik bei Bildprojektoren zu finden sind, wurde beobachtet, daß die Farbintensität nicht immer mit der vorgegebenen Filterwirkung übereinstimmte, es trat in einigen Fällen vielmehr eine merkbare Abflachung der Farbintensität auf.

Die Ursache hierfür liegt, wie herausgefunden wurde, in auftretenden Vielfachreflexionen des Lichtes, das ungerichtet zwischen Filter und hochreflektierendem Chip der Fotosensoren auftreten kann. Der Chip enthält nämlich nicht nur teilweise hochreflektierende Passivierungsschichten, sondern auch hochreflektierende Aluminiumschichten in unmittelbarer Nachbarschaft zu den Sensoren.

Erfindungsgemäß wird daher zur Behebung der geschilderten Erscheinung vorgeschlagen, alle optisch nicht genutzten Bereiche des Farbfilterträgers, insbesondere in der Nähe der Fotosensoren durch eine lichtdichte absorbierende oder reflektierende Schicht, die auf der Farbfilterschichtseite aufgebracht wird, zu maskieren, so daß ungerichtetes Licht nicht zwischen die Grenzflächen Chip-Filter
bzw. Chip-Substrat eintreten kann.

Darüberhinaus hat es sich als besonders vorteilhaft erwiesen, den Farbfilterträger bzw. das Substrat in
Immersion durch geeignete optische Kittmassen, wie z.B.
Methacrylatmassen mit dem Chip zu bringen, um die Brechwertunterschiede der Grenzflächen herabzusetzen.

Einzelheiten der Erfindung ergeben sich aus den
Unteransprüchen und der Beschreibung, worin im folgenden
anhand der Zeichnung Ausführungsbeispiele erörtert werden.
Es zeigen

Fig. 1     schematisch den Aufbau des ersten Streifensystems,

Fig. 2     schematisch den Aufbau des zweiten Streifensystems,

Fig. 3     schematisch den Aufbau des dritten Streifensystems,

Fig. 4     die Filterkurve für das grüne Streifensystem,

Fig. 5     die Filterkurve für das rote Streifensystem,

Fig. 6     die Filterkurve für das blaue Streifensystem,

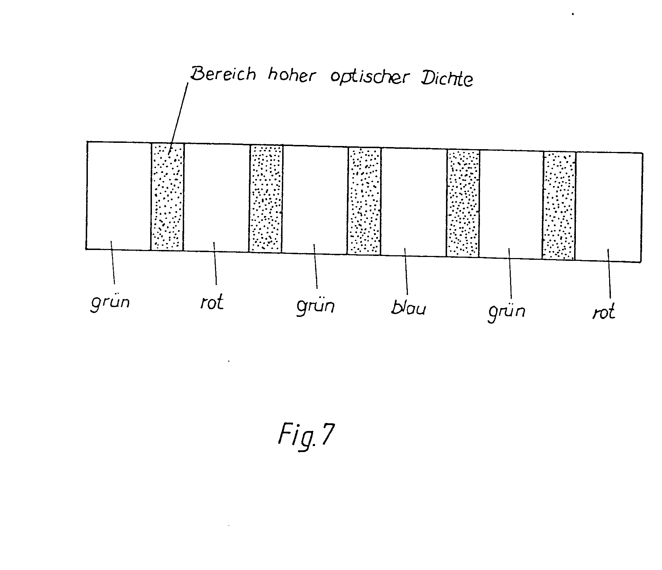

Fig. 7     schematisch eine Anordnung mit überlappenden
Farbfilterstreifen und

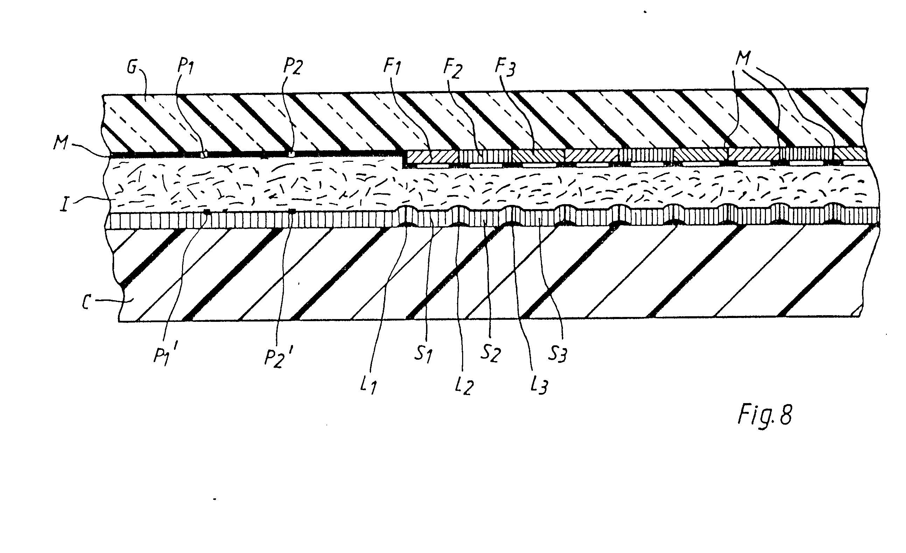

Fig. 8     einen schematischen Schnitt durch einen erfindungsgemäßen Fotoempfänger mit einem multichroitischen Farbstreifenfilter.

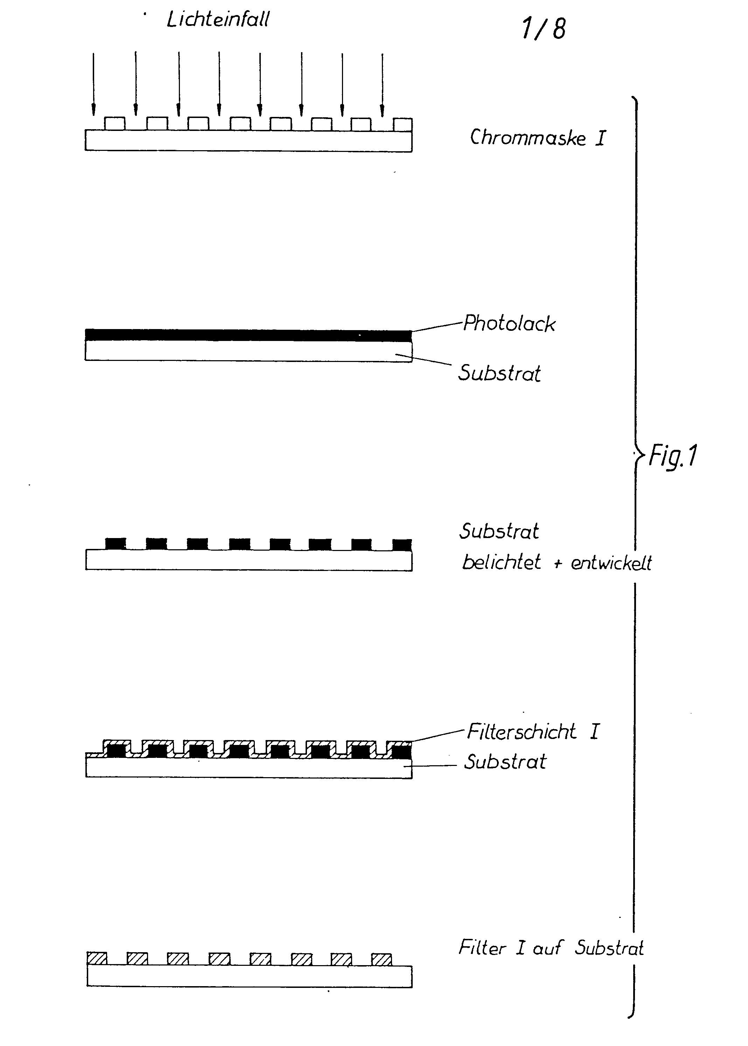

Für die Aufbringung der Filterstreifensysteme
sind nach geeigneten Vorlagen zunächst Chrommasken anzufertigen, die auf mit Fotolack beschichteten planparallel gearbeiteten Glassubstraten oder bei geeigneter Justierung
direkt auf die Oberfläche des Fotoempfängers durch Belichten abgebildet werden. Wie aus Fig. 1 ersichtlich, entstehen nach Entwickeln des Fotolacks freibleibende Fenster im Rastermaß des gewünschten Filterstreifens, beispielsweise 13 u breite und 100 u lange Felder.

Das so maskierte Substrat bzw. der so maskierte Fotoempfänger wird in eine Hochvakuumanlage gegeben und mit den gewünschten Interferenzschichten für zunächst eine Farbe (z.B. Filter I, grün) bedampft. Fotolack und Substrat werden gleichmäßige mit den Filterschichten belegt, wobei sich die Filterschicht jedoch nur mit den freiliegenden Bereichen des Glassubstrates äußerst haftfest verbindet.

Nach Entnahme aus der Vakuumanlage wird der Fotolack mit der daraufliegenden Filterschicht durch Aufquellen mit organischen Lösungsmitteln, vorzugsweise Dimethylketon abgehoben.

Die Kantenschärfe der auf dem Glassubstrat zurückbleibenden Farbstreifenfilter beträgt etwa 0,1 u.

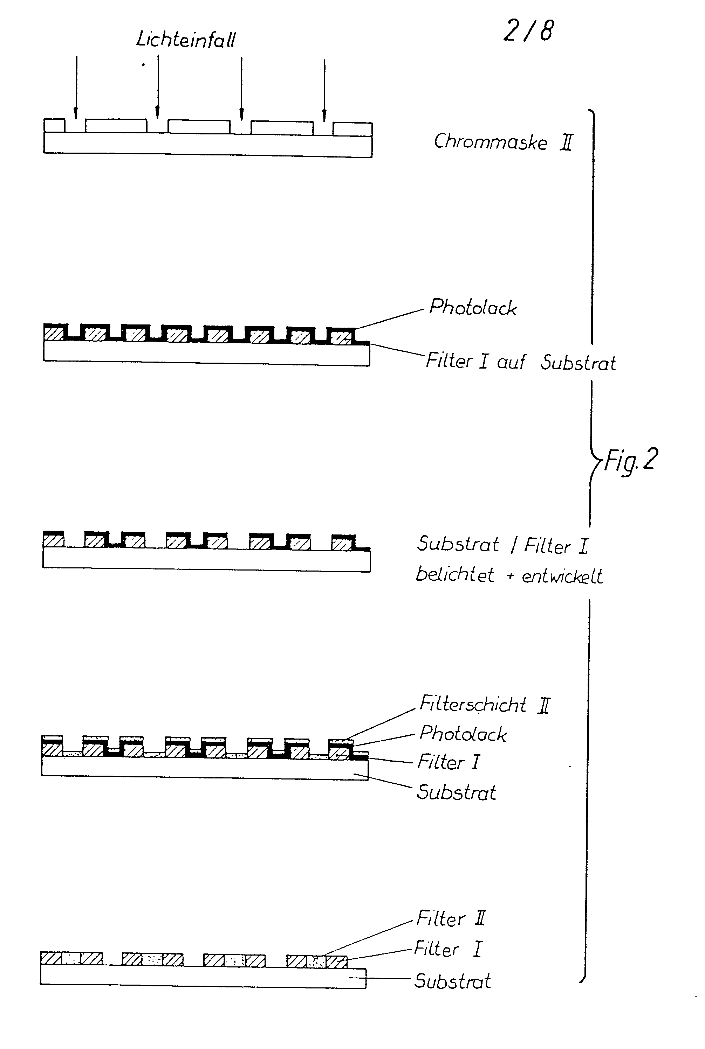

Das Farbstreifenfilter mit der Filterschicht I (grün) wird sodann wie in Fig. 2 dargestellt, erneut mit Fotolack beschichtet und die Chrommaske II, die in einer geeigneten Einrichtung des sogenannten Maskeliners über entsprechende Justierhilfen dem entsprechenden Rastermaß des Farbstreifensystems I auf + 0,15 u genau zujustiert wird, durch Belichtung abgebildet.

Das entwickelte Substrat wird erneut, jedoch mit Filterschicht II (rot) bedampft. Durch Abheben des Fotolacks mit Lösungsmittel werden nunmehr die gewünschten Farbstreifenfilter II freigelegt.

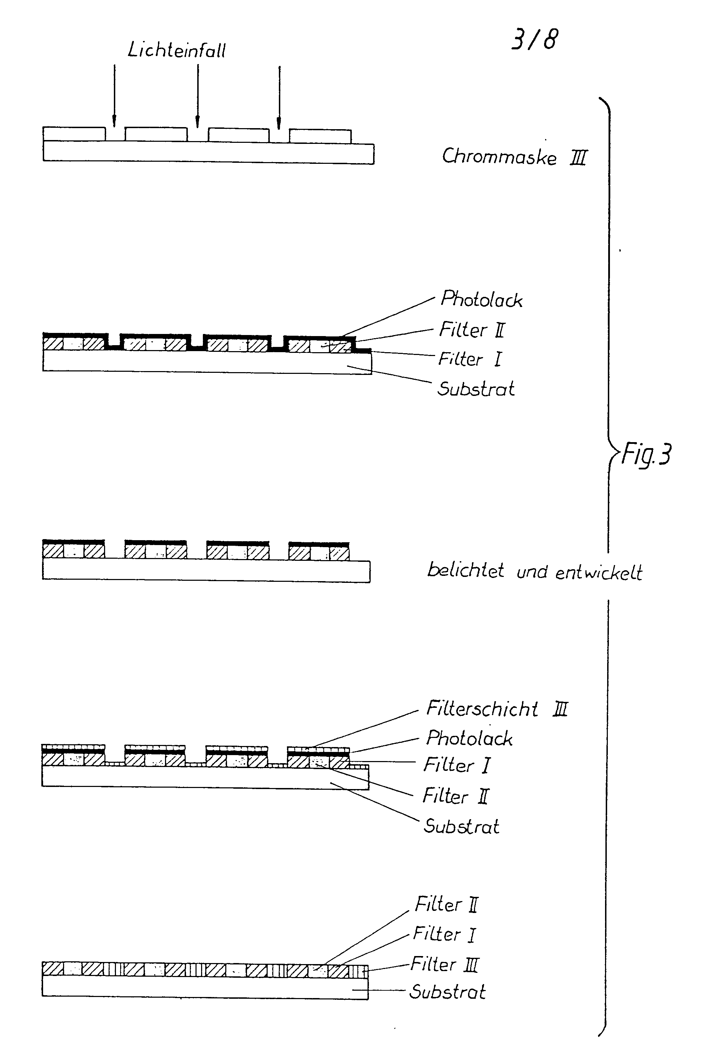

In einer weiteren Arbeitsfolge wird in analoger Weise, wie Fig. 3 zeigt, das Filter mit Farbfilterschicht III komplettiert.

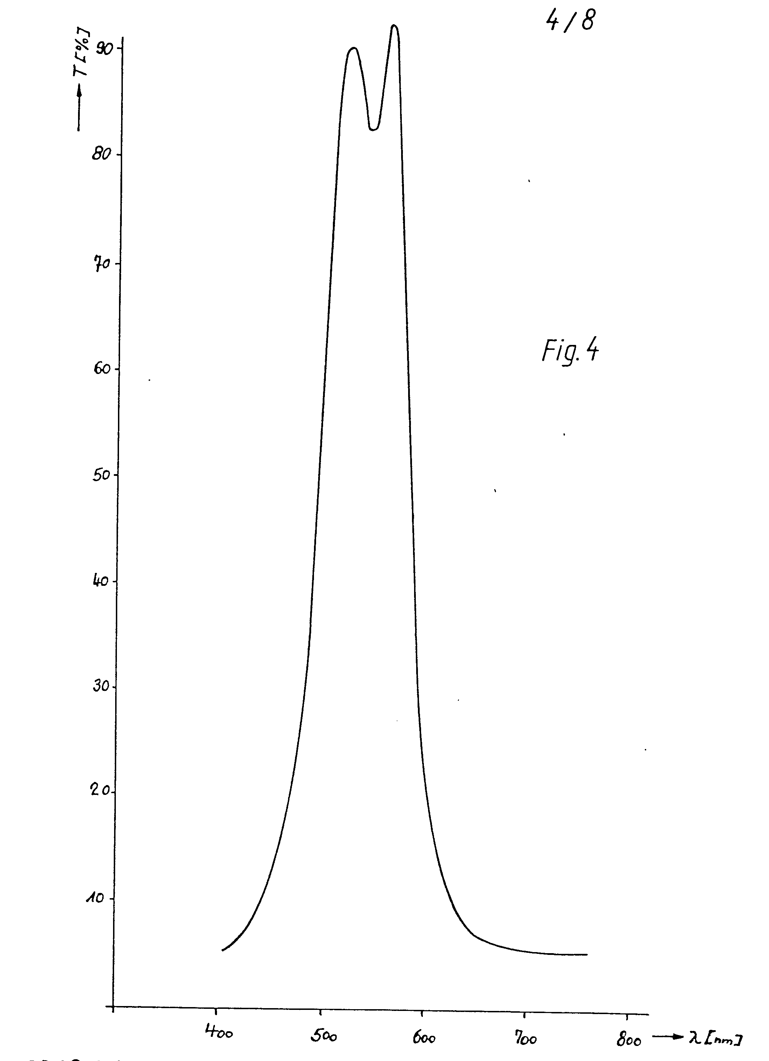

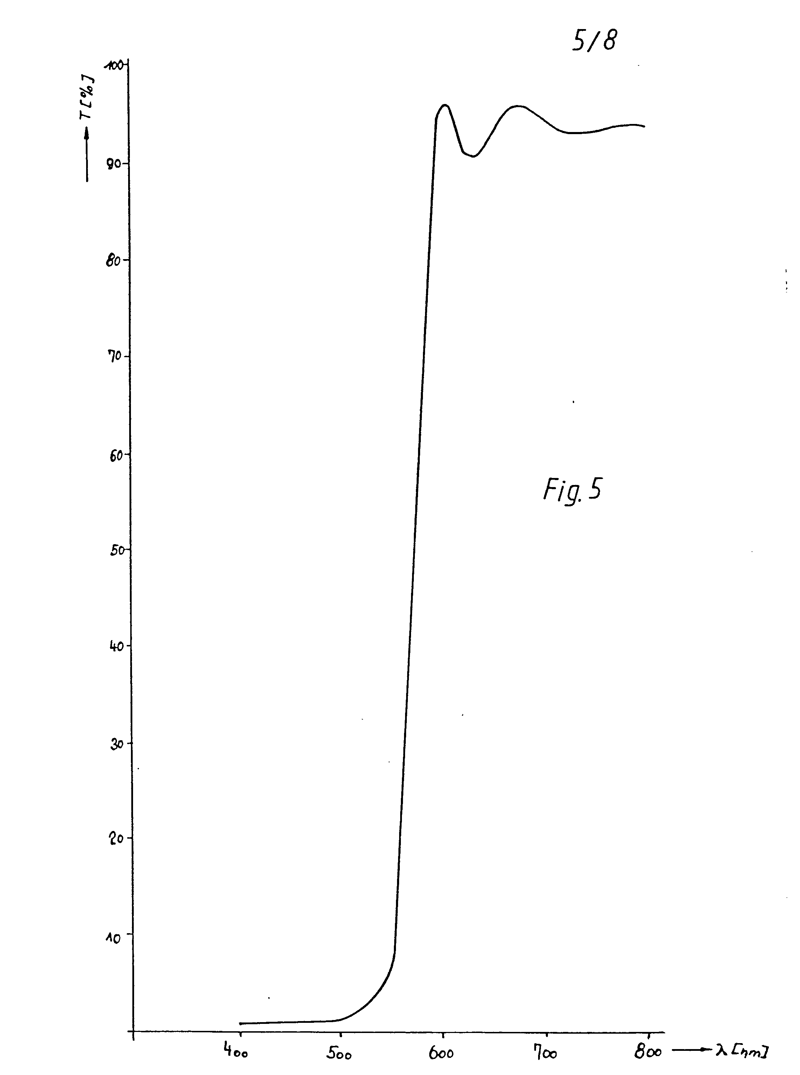

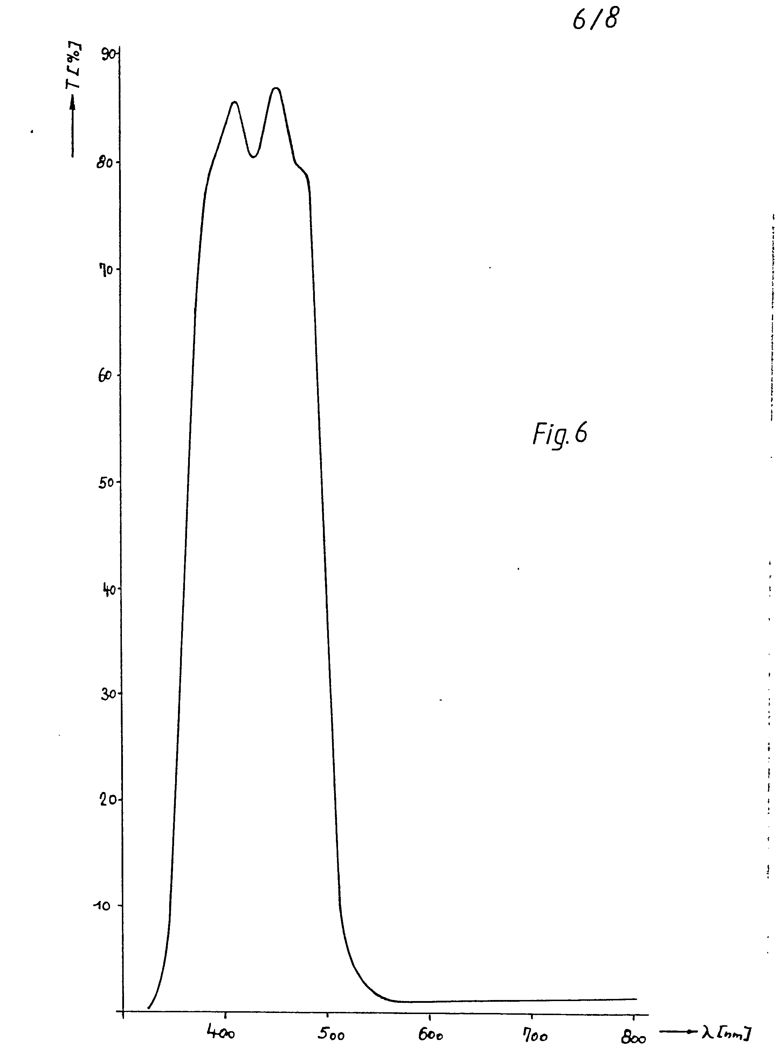

Der spektrale Verlauf der Farbstreifenfilter im Bereich 400 bis 800 nm ist, wie die Figuren 4, 5 und 6 zeigen, den in der Farbmetrik festgelegten Spektralwertkurven angeglichen.

Es ist aber auch möglich, durch Verschiebung der Spektralwertkurven Mängel in der spektralen Empfindlichkeit des Fotoempfängers zu kompensieren, beispielsweise mangelnde Blauempfindlichkeit durch Versatz der zugeordneten Filterkurve in Richtung auf die längeren Wellenlängen hin auszugleichen.

Wenn die Farbstreifenfilter auf einen separaten Glasträger aufgedampft werden, wird Ausschuß von kostspieligen Fotosensoren vermieden, und es ist optimale Anpassung der Interferenzschichtsysteme möglich. Die Abmessungen der Farbstreifen werden so gewählt, daß sie etwa um Faktor 8 länger sind als die Fotoempfänger. Dadurch wird es möglich, bei eventuellen Störstellen in den Filtern (Pinholes) diesen durch Justage auszuweichen.

Für die Massenfertigung lohnt es sich jedoch, unter Umgehung zusätzlicher Justiervorrichtungen die Fotoempfänger direkt zu beschichten, und zwar zweckmäßig bereits die Beschichtung auf dem Wafer vorzunehmen.

Durch die beschriebene Abhebetechnik ist hohe Kanten- und Trennschärfe der Filterstreifen möglich. Zweckmäßig werden Positivlacke verwendet, die mindestens 1 u stark aufgetragen werden. Um eine Beeinflussung durch den Ablösevorgang zu vermeiden, werden chemisch und mechanisch äußerst stabile Aufdampfsubstanzen, beispielsweise als hochbrechende Materialien $Ta_2O_5$, $TiO_2$, $CeO_2$, $ZnS$ und dergleichen bzw. als niederbrechende Materialien $MgF_2$, $SiO_2$, $ThoO_2$ und dergleichen verwendet.

Gemäß Fifur 8 befinden sich auf einem an sich bekannten und hier nicht näher dargestellten Chip C nebeneinander angeordnet kleine lichtempfindliche Bereiche S1, S2 und S3, die für verschiedene Farben, und zwar für blau, grün und rot empfindlich sein sollen. Diese unterschiedliche Empfindlichkeit wird in bekannter Weise durch ein vor den Empfängern angebrachtes Farbstreifenfilter mit entspre-

chend transparenten Streifen F1, F2 und F3 erreicht. Die Herstellung des Filters und Einzelheiten seines Aufbaues sind in der Hauptanmeldung beschrieben.

Wie aus der Figur ersichtlich ist, sind die lichtempfindlichen Bereiche S1, S2 und S3 lückenlos aneinandergesetzt und weisen eine Oberflächenwelligkeit auf, die wegen der unter den Trennstellen der Bereiche angebrachten Leiter L1, L2 und L3 zustandekommt.

Um eine exakte Farbtrennung der einzelnen Sensoren zu erreichen und um zu vermeiden, daß an den Trennfugen der einzelnen Farbfilter F1, F2 und F3, die z.B. durch geringfügige Justierungenauigkeiten entstehen können, ungefiltertes Licht einfällt, werden deshalb gemäß der Erfindung die Trennfugen sowie auch die umliegenden Bereiche des Substrates, die keine Filterstreifen tragen, mit einer lichtdichten Maske M abgedeckt.

Zweckmäßig ist diese Maske aus Metall, vorzugsweise Chrom. Sie wird abschließend auf die Filteroberfläche aufgedampft.

Die paßgenaue Justierung der Farbstreifenfilterleiste auf dem Chip erfolgt im Auflicht eines geeigneten Mikroskopes unter Zuhilfenahme zweier Sätze von Paßmarken $P_1$ und $P_2$, die möglichst weit voneinander entfernt vorzugsweise an den beiden Enden des Glassubstrates in der Chrommaske M enthalten und mit entsprechenden Sätzen von Marken $P_1'$ und $P_2'$ auf dem Chip C zur Deckung zu bringen sind. In der Figur ist nur einer der Paßmarkensätze an einem Ende der erfindungsgemäßen Vorrichtung dargestellt. Im übrigen braucht dieser Satz nicht aus zwei Marken $P_1$ und $P_2$ zu bestehen, sondern es können auch mehrere Marken in einem Satz enthalten sein oder es kann mit nur einer einzigen Marke pro Satz gearbeitet werden.

Die Oberflächentopographie des CCD-Chips läßt keinen direkten Kontakt zwischen Fotosensoren und aufgesetztem Farbfilterstreifen zu. In jedem Fall entsteht zwischen Farbfiltern und Fotosensoren ein Luftspalt.

Um die Brechungsindexübergänge zwischen den Grenzflächen Filteroberseite zu Luft und Luft zu Fotosensor und die daraus resultierenden Vielfachreflexionen zu verringern, wird der Luftspalt zwischen C und M mit einer optisch transparenten, streulichtfreien Kittmasse I ausgefüllt, deren Brechungsindex nach Aushärtung zwischen 1,5 und 1,6 (bezogen auf eine mittlere Wellenlänge $n_d$) liegt.

Die Schichtstärke der Kittmasse I ist zweckmäßig möglichst gering. Sie ergibt sich aus der maximal möglichen Annäherung zwischen Chip und Farbstreifenfilter. In der Figur ist die Schichtstärke der besseren Übersichtlichkeit halber stark überhöht dargestellt.

# AGFA-GEVAERT AG 0037529

LEVERKUSEN

CAMERA-WERK MÜNCHEN
PATENTABTEILUNG

CW 2362.1 PO/MO

01.04.81

10-hl

0336C

Patentansprüche

1. Verfahren zur Herstellung eines Fotoempfängers mit einem multichroitischen Farbstreifenfilter, dadurch gekennzeichnet, daß die ineinandergeschachtelten Filterstreifensysteme in aufeinanderfolgenden Verfahrensstufen jeweils unter Beschichten des Substrates mit Fotolack, Aufbelichten einer jedem Streifensystem zugeordneten Maske, Entwickeln des Fotolacks, Aufdampfen der gewünschten Interferenzschichten für die betreffende Filterfarbe und anschließendem Ablösen des verbliebenen Fotolacks aufgebracht werden.

2. Verfahren nach Anspruch 1, dadurch gekennzeichnet, daß der Fotolack mit den darauf liegenden, überflüssigen Filterschichten durch Aufquellen mit organischen Lösungsmitteln, vorzugsweise Dimethylketon, abgehoben wird.

3. Verfahren nach Anspruch 1, dadurch gekennzeichnet, daß als Fotolack Positivlack in einer Schichtstärke von wenigstens 1 u verwendet wird.

4. Verfahren nach einem der vorhergehenden Ansprüche, dadurch gekennzeichnet, daß zur Erzeugung der Filterschichten chemisch und mechanisch stabile Aufdampfmaterialien, z.B. hochbrechende Materialien wie $Ta_2O_5$, $TiO_2$, $CeO_2$, ZnS und dergleichen bzw. niederbrechende Materialien wie $MgF_2$, $SiO_2$, $ThoO_2$ und dergleichen verwendet werden.

5. Verfahren nach einem der vorhergehenden Ansprüche, dadurch gekennzeichnet, daß als Substrat eine planparallele Glasplatte verwendet und nach Aufbringung des Streifenfilters mit dem Fotoempfänger unter Justierung verbunden wird.

6. Verfahren nach einem der vorhergehenden Ansprüche, dadurch gekennzeichnet, daß als Substrat der Fotoempfänger verwendet wird.

7. Verfahran nach Anspruch 1, dadurch gekennzeichnet, daß alle optisch nicht genutzten Bereiche des Farbfilterträgers, insbesondere in der Nähe der Fotosensoren durch eine lichtdichte absorbierende und/oder reflektierende, auf der Farbfilterschichtseite aufgebrachte Schicht maskiert werden.

8. Verfahren nach Anspruch 7, dadurch gekennzeichnet, daß der Maskenrahmen aus einer in Transmission gesehen lichtdichten Schicht aus Metall besteht.

9. Verfahren nach Anspruch 7, dadurch gekennzeichnet, daß der Maskenrahmen auf der Filterschichtseite aufgebracht wird.

10. Verfahren nach Anspruch 7, dadurch gekennzeichnet, daß der Maskenrahmen mindestens zwei Justiermarken enthält, die sich mit entsprechend gleichen auf dem Chip zur Deckung bringen lassen.

CW 2362.1 PO/MO-EP

11. Verfahren nach Anspruch 10, dadurch gekennzeichnet, daß der Maskenrahmen mindestens zwei Justiermarken enthält, die sich mit jeweils zugeordneten Paßmarken, die mit der Chrom-Maske I für das erste Farbstreifenfilter bereits abgebildet wurden, zur Deckung bringen lassen.

12. Verfahren zur Herstellung eines Fotoempfängers mit einem multichroitischen Farbstreifenfilter, bei dem die ineinandergeschachtelten Filterstreifensysteme in aufeinanderfolgenden Verfahrensstufen jeweils unter Beschichten des Substrates mit Fotolack, Aufbelichten einer jedem Streifensystem zugeordneten Maske, Entwickeln des Fotolacks, Aufdampfen der gewünschten Interferenzschichten für die betreffende Filterfarbe und anschließendem Ablösen des verbliebenen Fotolacks aufgebracht werden, dadurch gekennzeichnet, daß die Farbstreifenfilter bzw. das Substrat mittels Kittmasse in Immersion mit der Chip-Oberfläche gebracht wird.

13. Verfahren nach Anspruch 12, dadurch gekennzeichnet, daß die Farbstreifenfilter mit der Filterschichtseite auf der Chip-Oberfläche mittels Kittmasse aufgebracht werden.

14. Verfahren nach Anspruch 13, dadurch gekennzeichnet, daß die Kittmassen aus ein- oder mehreren Komponenten bestehen, die nach Aushärtung transparente, streulichtfreie elektrisch gut isolierende Haftschichten bilden.

15. Verfahren nach Anspruch 14, dadurch gekennzeichnet, daß die Kittmassen einen Brechnungsindex im Bereich $n = 1,5$ bis $1,6$ aufweisen.

16. Fotoempfänger mit einem multichroitischen Farbstreifenfilter, dadurch gekennzeichnet, daß der Farbstreifenfilter auf eine planparallele Trägerplatte aufgedampft ist, daß die Länge der Filterstreifen größer als die Breite der wirksamen Fläche des Fotoempfängers ist und daß die Trägerplatte mit dem Fotoempfänger verbunden ist.

17. Fotoempfänger mit einem multichroitischen Farbstreifenfilter, dadurch gekennzeichnet, daß der Farbstreifenfilter auf die Oberfläche des Fotoempfängers in mehreren Verfahrensstufen aufgedampft ist.

18. Fotoempfänger nach Anspruch 17, dadurch gekennzeichnet, daß bei aneinander unmittelbar anschließenden lichtempfindlichen Bereichen die Filterstreifen einander so weit überlappen, daß der Grenzbereich zwischen zwei benachbarten lichtempfindlichen Bereichen des Fotoempfängers durch einen Filterbereich gesperrter Transparenz abgeschirmt ist.

19. Fotoempfänger nach Anspruch 17, dadurch gekennzeichnet, daß die Länge der Filterstreifen des Farbstreifenfilters größer als die Breite der wirksamen Fläche des Fotoempfängers ist.

20. Fotoempfänger mit einem multichroitischen Farbstreifenfilter, dadurch gekennzeichnet, daß alle optisch nicht genutzten Bereiche des Farbfilterträgers, insbesondere in der Nähe der Fotosensoren durch eine lichtdichte absorbierende und/oder reflektierende, auf der Farbfilterschichtseite aufgebrachte Schicht maskiert sind.

21. Fotoempfänger nach Anspruch 20, dadurch gekennzeichnet, daß der Maskenrahmen aus einer in Transmission gesehen lichtdichten Schicht aus Metall besteht.

22. Fotoempfänger nach Anspruch 20, dadurch gekennzeichnet, daß der Maskenrahmen mindestens zwei Justiermarken enthält, die sich mit entsprechend gleichen auf dem Chip zur Deckung bringen lassen.

23. Fotoempfänger nach Anspruch 20, dadurch gekennzeichnet, daß der Maskenrahmen mindestens zwei Justiermarken enthält, die sich mit jeweils zugeordneten Paßmarken, die mit der Chrom-Maske I für das erste Farbstreifenfilter bereits abgebildet wurden, zur Deckung bringen lassen.

24.      Fotoempfänger mit einem multichroitischen Farbstreifenfilter, dadurch gekennzeichnet, daß die Farbstreifenfilter bzw. das Substrat mittels Kittmasse in Immersion mit der Chip-Oberfläche gebracht sind.

25.      Fotoempfänger nach Anspruch 24, dadurch gekennzeichnet, daß die Farbstreifenfilter mit der Filterschichtseite auf der Chip-Oberfläche mittels Kittmasse aufgebracht sind.

26.      Fotoempfänger nach Anspruch 24, dadurch gekennzeichnet, daß die Kittmassen aus ein- oder mehreren Komponenten bestehen, die nach Aushärtung transparente, streulichtfreie elektrisch gut isolierende Haftschichten bilden.

27.      Fotoempfänger nach Anspruch 26, dadurch gekennzeichnet, daß die Kittmassen einen Brechungsindex im Bereich $n = 1,5$ bis $1,6$ aufweisen.

Hierzu 8 Blatt Zeichnungen

Lichteinfall

Chrommaske I

Photolack

Substrat

Substrat
belichtet + entwickelt

Filterschicht I

Substrat

Filter I auf Substrat

Fig.1

CW 2362.1 PO/MO

Lichteinfall

Chrommaske II

Photolack

Filter I auf Substrat

Substrat / Filter I
belichtet + entwickelt

Fig.2

Filterschicht II
Photolack
Filter I
Substrat

Filter II
Filter I
Substrat

CW 2362.1 P0/M0

Lichteinfall

Chrommaske Ⅲ

Photolack
Filter Ⅱ
Filter Ⅰ
Substrat

Fig.3

belichtet und entwickelt

Filterschicht Ⅲ
Photolack
Filter Ⅰ
Filter Ⅱ
Substrat

Filter Ⅱ
Filter Ⅰ
Filter Ⅲ
Substrat

0037529

4/8

Fig. 4

CW 2362.1 PO/MO

Fig. 5

0037529

5/8

CW 2362.1 PO/MO

Fig.6

Bereich hoher optischer Dichte

grün        rot        grün        blau        grün        rot

Fig. 7

CW 2362 1 PO/MO

Fig. 8

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A1 - 2 745 288 (EASTMAN) <br> + Seiten 2-5, Ansprüche 8-11; Seite 14, Zeile 22 - Seite 15, Zeile 5; Fig. 4a-4f; Seite 28, Zeile 4 - Seite 31, Zeile 33 + <br><br> -- <br><br> DE - A1 - 2 554 613 (HITACHI) <br> + Seite 2, Zeilen 9-13; Fig. 2; Seite 5, Zeilen 6-13, Zeile 25 - Seite 6, Zeile 7 + <br><br> -- <br><br> DE - B - 2 218 317 (OPTICAL) <br> + Spalte 1, Zeile 68 - Spalte 3, Zeile 6; Spalte 4, Zeile 47 - Spalte 9, Zeile 61; Fig. 4-10 + <br><br> -- <br><br> DE - B2 - 2 355 851 (OPTICAL) <br> + Fig. 1-10; Spalte 1, Zeilen 4-56; Spalte 3, Zeile 46 - Spalte 6, Zeile 54 + <br><br> ---- | 1,2,5, 6,12,24 <br><br><br><br><br><br> 4,5, 7-9,20, 21 <br><br><br><br><br> 1-5 <br><br><br><br><br><br> 1,2,4 |

**KLASSIFIKATION DER ANMELDUNG (Int. Cl.³)**

G 03 F 7/00
G 02 B 5/28
H 04 N 9/04

**RECHERCHIERTE SACHGEBIETE (Int Cl.³)**

G 01 J 1/00
G 02 B 5/00
G 03 B 11/00
G 03 C 1/00
G 03 C 5/00
G 03 F 9/00
H 01 J 29/00
H 04 N 9/04

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 03-07-1981 | BENISCHKA |